Europäisches Patentamt

European Patent Office

Office européen des brevets

Publication number: **0 287 811**

**A1**

# EUROPEAN PATENT APPLICATION

Application number: 88104340.0

Int. Cl.4 **H01L 29/10 , H01L 29/80**

Date of filing: **18.03.88**

Priority: **23.04.87 US 41814**

Date of publication of application:
**26.10.88 Bulletin 88/43**

Designated Contracting States:
**DE FR GB IT**

Applicant: **International Business Machines Corporation**
**Old Orchard Road**
**Armonk, N.Y. 10504(US)**

Inventor: **Jackson, Thomas N.**
**80 Cortlandt Avenue**
**Peekskill, N.Y. 10566(US)**

Representative: **Gaugel, Heinz, Dipl.-Ing.**
**IBM Deutschland GmbH Schönaicher**
**Strasse 220**
**D-7030 Böblingen(DE)**

Field effect transistor and method of making.

A semiconductor structure having an extrinsic conductivity type surface layer (3) with a vertically and horizontally precisely located different conductivity buried region (5) that facilitates construction of a self-aligned controlled cross section short channel FET comprising source and drain electrodes (11, 12) and a gate electrode (13).

## FIG. 8

EP 0 287 811 A1

# FIELD EFFECT TRANSISTOR AND METHOD OF MAKING

The invention relates to the fabrication of very small dimension semiconductor structures wherein electrodes are placed close to each other on a surface of a semiconductor device. In such a structure. as dimensions become smaller, the effect in the semiconductor of the close electrodes limits performance.

A particular example of the type of device to which this invention applies is that of a field effect transistor.

As field effect transistors have increased in speed and the integrated circuits in which they are used have increased in density, the need for both vertical and horizontal, very precise accurate dimensioning of a signal carrying portion of a semiconducotr, has become acute. In turn, however, dimensioning requirements have been complicated by electric fields emanating from device electrodes and interfaces which produce regions depleted of carriers in the semiconductor.

In the art, precision in dimensioning has been achieved using the implantation of a buried region which can serve for alignment purposes. This technique is illustrated in U.S. Patent No. 4,514,893.

Efforts to provide small channel regions by converting a portion of the surface adjacent the gate are shown in Extended Abstracts of Conference on Solid State Devices and Materials, Tokyo, 1985. p.417 and IEEE IEDM-85, page 90.

The invention as claimed solves the problem of how to achieve accurate dimensioning required in connection with small high speed field effect transistor.

Fig. 1 is a schematic view of the intermediate manufacturing product structure of the invention.

Figs. 2 and 3 are schematic illustrations of the substrate and masking layer with an opening into which implantation is to be performed in connection with the invention.

Figs. 4 and 5 are graphs showing the doping concentration with respect to distance from the surface and the net doping with respect to distance from the surface produced by implantation through the opening in Fig. 3.

Fig. 6 is a schematic view of the relation of the buried extrinsic region to the mask opening in the fabrication of the invention.

FIGS. 7 and 8 are schematic views of the structure in fabricating a field effect transistor employing the intermediate manufacturing product of the invention.

The invention involves a precisely positioned buried region of different conductivity that operates to reduce the cross section of a current path in a semiconductor device and to constrain depletion regions emanating from nearby contacts in that current path.

An intermediate manufacturing product structure is produced consisting of a relatively thin, device quality, first conductivity type region on a monocrystalline substrate containing, generally at the buried interface of the region and the substrate, a precisely located opposite or reduced conductivity type inclusion positioned beneath the surface a distance compatible with the thickness dimension of a current path.

The structure facilitates fabrication of a self-aligned short channel field effect transistor structure and provides an improved process of making such a transistor.

While a number of substitutions will be apparent to one skilled in the art, for purposes of simplicity of explanation, the invention will be described in connection with a number of process steps employed in fabrication.

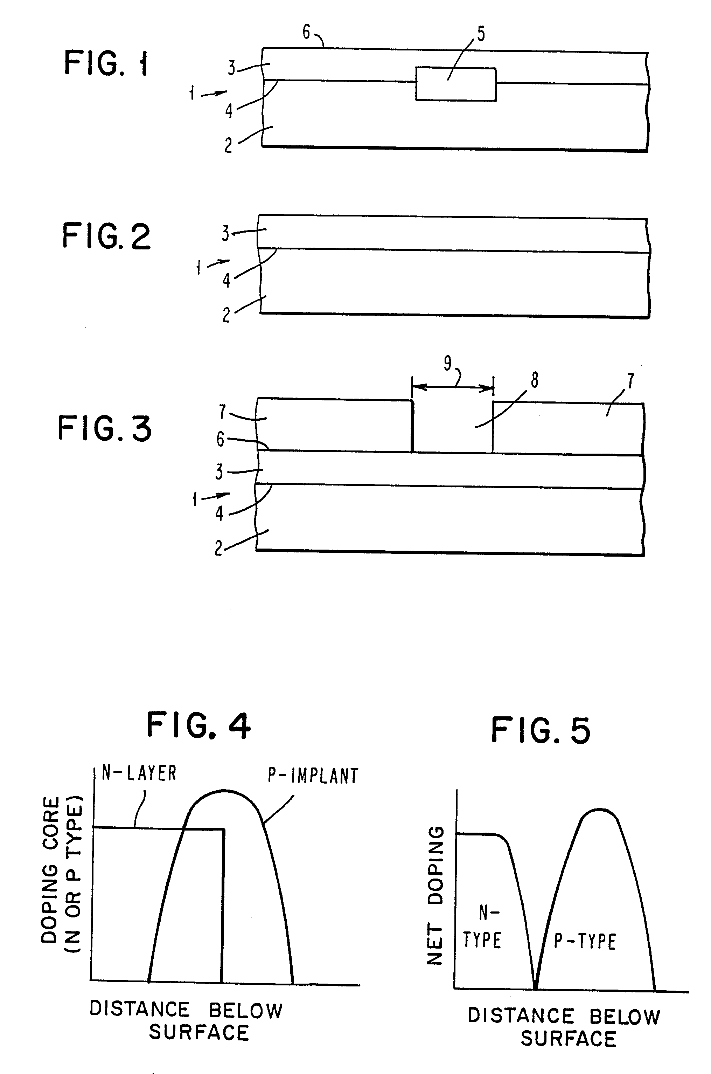

Referring to FIG. 1, a monocrystalline semiconductor substrate 1 is provided having a supporting layer 2 and a first extrinsic conductivity type device layer 3 meeting layer 2 at an interface 4. A region 5 is provided that is precisely positioned in respect to both horizontal and vertical relationship to the surface 6. The region 5 is provided with opposite or reduced extrinsic conductivity type to said layer 3.

The structure of FIG. 1 when incorporated in a semiconductor device structure as a current path, such as a structure where the layer 3 is a portion of a field effect transistor, the region 5 operates to reduce the cross sectional area of layer 3. When the reduced cross sectional area region is employed as the channel of an FET transistor, the reduced cross sectional area provides precise channel resistance capability and inhibits charge injection into the supporting layer 2 from nearby source and drain ohmic contacts on the channel region between the region 5 and the surface 6. The region 5 is about 10 nm to 200 nm beneath the surface 6.

The structure of FIG. 1 may be fabricated in several ways, such as by providing conductivity type determining impurities on the interface 4 as the member I is grown, or through the use of ion implantation through the surface 6.

The features and advantages of the invention are illustrated in connection with the following description of the steps in fabrication.

Referring to FIG. 2, a monocrystalline semiconductor structure 1 employs a supporting substrate 2 with a thin extrinsic conductivity type layer 3.

For purposes of simplicity of explanation, the extrinsic conductivity type of the layer 3 may be considered n type. The layer 3 can be produced by ion implantation of the substrate 1 or it may be grown epitaxially by one of the standard techniques well known in the art.

The conductivity of the layer 3 is greater than that of a typical channel layer of a field effect transistor.

Referring next to FIG. 3, a masking layer of for example an ion implantation resistant insulating dielectric 7 of, for example, silicon nitride or silicon dioxide is positioned on the exposed surface 6 of the layer 3. The layer 7 has an opening 8 with precise lateral dimensions, one direction of which is shown as element 9 that will be related to the current path in the device being fabricated. In the submicron type devices being constructed at the present state of the art, the dimension 9 may be of the order of 500 nm. The opening 8 and layer 7 can be made by standard techniques in the art for providing precisely dimensioned openings in layers such as by photolithography, followed by reactive ion etching.

Referring next to FIGS. 4 and 5, these are graphs of the doping conditions in the structure 1 when the technique of ion implantation is employed through the opening 8.

In the technique of semiconductor ion implantation, dopant impurity atoms are driven in and implanted in the semiconductor crystal through a surface with a sufficient force that a specific impurity concentration may be selected to be at a particular location beneath the entry surface.

In FIG. 4, continuing the assumption that the layer 3 of FIG. 2 is n type and the n doping thereof is as illustrated by the curve labelled n-layer, when p conductivity type impurity atoms are implanted through the opening 8 and surface 6 there can be selected a particular concentration of p type impurities a selected distance below the surface, in this example at the interface 4.

Referring next to FIG. 5, since the net doping is the predominance of one type over the other, the portion of layer 3 coinciding with the opening 8 will remain n type while farther from the surface a region will be produced that is p type.

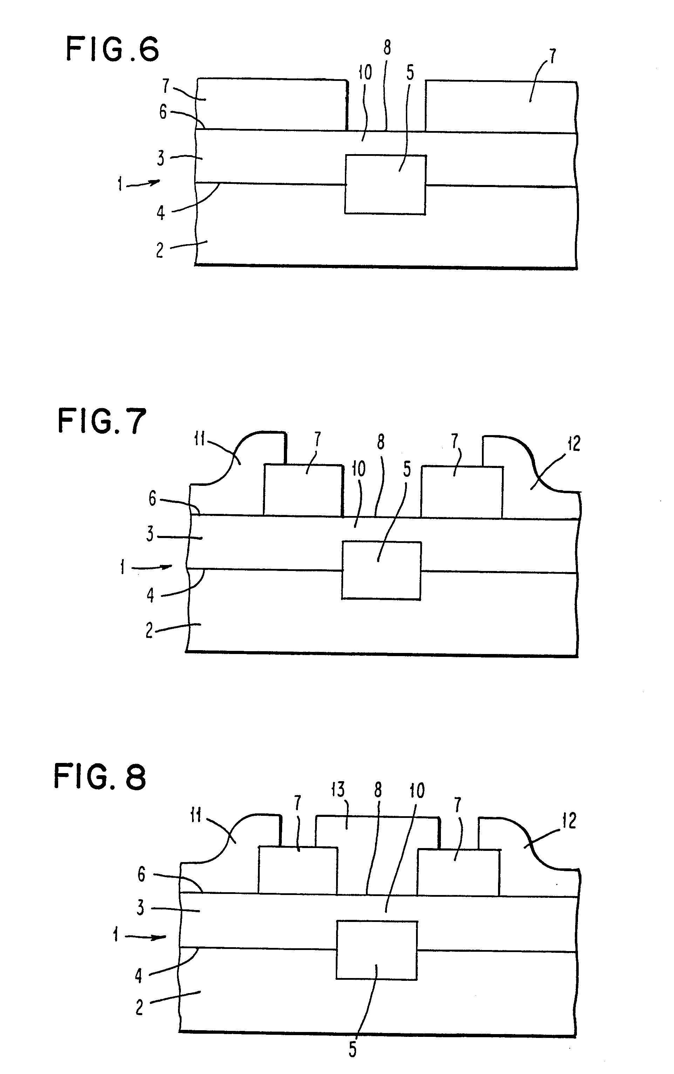

The p region 5 is illustrated in FIG. 6. In FIG. 6, it will be seen that the doping concentration below the surface 6 when p type impurities are driven into and subsequently annealed in the layer 3 through opening 8 in a predominant concentration in the vicinity of interface 4, a p-conductivity type region 5 is produced which operates to reduce the cross-sectional area of the layer 3 directly under the opening 8. This reduced area is labelled 10.

The p conductivity type region 5 may be described as a subtractive implant buried region in which the implanted dopants subtract from and convert the conductivity of the opposite type. This region inhibits lateral dimension movement of fields that are associated with electrodes positioned on the surface 6 near opening 8, an example of this being the injection of undesirable charge below the channel from source and drain contacts in small dimension field effect transistors.

The advantage of the selectable conductivity and dimensionality of the reduced area 10 is that a field effect transistor (FET) may now be readily made that is either the enhancement mode or the depletion mode type depending on the choice of doping concentration relationship between the p implant region 5 and the constructed conductivity of the reduced area 10 portion of the n layer 3.

Since the enhancement mode type FET device differs from a depletion mode type FET device by the fact that a signal on a gate positioned adjacent the channel can completely deplete the channel of carriers and thereby turn the device completely off, the region 10 relaxes the specifications needed to produce this condition.

In fabricating an FET transistor, a gate opening mask has been applied in the opening 8 of FIG. 6 and portions of the dielectric 7 have been removed down to the surface 6 so that each remaining portion is of the order of 1000 nm.

Referring next to FIG. 7, the gate opening mask has been removed and the source 11 and drain 12 electrodes have been applied in contact with the surface 6 and extending onto the dielectric element 7. Masking is then provided that will control metal deposited in the gate opening 8 from extending to and shorting the source 11 and drain 12 electrodes.

Referring to FIG. 8, the gate electrode 13 has been applied. The electrode is shown - schematically as element 13, and, depending on the type of device being constructed may include an insulator adjacent surface 6 or provide a rectifying barrier at surface 6, such as a Schottky, or p,n junction.

A field effect transistor device is achieved with the invention in which the gate dimension chosen with the dimension 9 in FIG. 3 is related to the channel length, cross sectional area and conductivity of the portion 10 so that the net doping produced by the subtractive implant that produces region 5 can control whether a given signal on the gate 13 will produce enhancement or depletion mode operation.

It will be apparent to one skilled in the art that a number of substitutions may be employed. If the original n layer 3 is limited to the desired device area, isolation becomes automatic. However, where the n layer 3 is a large area, such as a wafer, isolation can be provided at the start of the process by mesa etching or after the annealing of the p-type implant forming region 5 by further implantation with protons (hydrogen), oxygen or boron, or with isolating p-type implants.

The selection of enhancement and depletion mode operation devices can be fabricated by using two different p-type implants or by employing one implant but implanting through varying cap thicknesses or gate recesses. In other words, the subtractive implant controlled in the area defined by dimension 9 and in depth as described in connection with FIGS. 4 and 5, results in, at a precise depth below the exposed surface 6 of the crystal a condition where the p-type concentration reduces that of the n in a localized region. That region can be made of different area depending on how much crystal is exposed and of different depth depending on how the dopant is introduced. It also follows that the subtractive implant need not completely convert to opposite conductivity but can locally reduce the n-type concentration only where desired.

It will further be apparent that the gate 13 may be deposited before the ohmic contacts 10 and 11 with a suitable gate metallurgy choice.

The invention produces a number of subtle advantages.

There need be no gate 13 material in contact with the exposed surface 6 of the semiconductor during the ion implantation annealing. Since the material of gate 13 does not see the high temperature of the annealing, then a wider range of materials and/or cleaning techniques can be employed.

Since the self-alignment of source 11 and drain 12 electrodes with respect to gate 13 is not done by implanted regions which require a heat based annealing step, fuzzy margins of region borders caused by diffusion straggle does not take place.

The implanted p-type region 5 reduces the field progression below the channel from the source 11 and drain 12 electrodes. This progression is known in the art as short channel effect.

The intermediate manufacturing product of the invention and the process of manufacture thereof is particularly well suited to the use of high quality epitaxial n-layers 3 which can have improved transport properties and carrier profiles.

The structure and process are adapted to ion implantation and annealing employing p conductivity type dopants, which dopants exhibit better activation response in annealing than n type for high energy dose implants.

Best Mode For Carrying Out The Invention

The preferred materials and process techniques for providing a short channel FET as illustrated in FIG. 8 are:

Layer 2 - semi-insulating GaAs substrate 0.5 millimeters thick

Layer 3 - epitaxial GaAs n conductivity type. doped. with $2 \times 10^{18}$ atoms/cm$^3$ 50nm thick.

Layer 6 - p conductivity type doped with Mg in a concentration of $2 \times 10^{13}$ atoms/cm$^2$ produced by ion implantation at 50 KV followed by rapid thermal annealing at 900°C for 2 seconds.

Dielectric 7 - Si$_3$N$_4$ vapor deposited by plasma enhanced chemical vapor deposition at 300°C, 500nm thick
Source and drain 11-12 are alloy contacts of Au/Ge/Ni.

Gate 13    Aluminum metal

What has been described is a semiconductor structure having an extrinsic conductivity type surface layer with a vertically and horizontally precisely located different conductivity buried region that facilitates construction of a self-aligned controlled cross section short channel FET.

Claims

1. A field effect transistor comprising in combination

a monocyrstalline device layer (3) of a first extrinsic conductivity having an exposed surface (6),

at least one dielectric member (7) in contact with said surface (6) having at least a portion (8) thereof defining at least one dimension (9) of an exposed area of said surface,

a region (5) in said device layer having a different conductivity being vertically separated from said surface (6) and being in area coextensive with said exposed area,

a gate electrode (13) in contact with said exposed area of said surface (6), and

source and drain ohmic electrodes (11, 12) in contact with exposed areas of said surface (6), each separated from said exposed area of said surface.

2. The transistor of claim I wherein said monocrystalline device layer (3) is n type GaAs.

3. The transistor of claim 1 or 2 wherein said region (5) in said monocyrstalline device layer (3) is p conductivity type.

4. The transistor of claims 1 to 3 wherein said vertical separation from said surface (6) of said p type region is 10 nm to 200.

5. A field effect transistor of the type having source and drain electrodes (11, 12) separated by a first conductivity channel current path and having a gate electrode (13) adjacent the surface (6) of said channel and in current influencing proximity thereto, the improvement comprising:

a region (5) of a second conductivity different from said first conductivity separated from said surface (6) of said channel coextensive in area with said surface of said channel adjacent said gate (13) and operable to reduce the effective cross sectional area of said channel.

6. The transistor of claim 5 wherein said region (5) of second conductivity is a subtractive implanted region.

7. The transistor of claim 5 or 6 wherein said channel current path is n conductivity GaAs and said region (5) of second conductivity is p conductivity type.

8. The process of forming a field effect transistor comprising in combination applying a layer (7) of dielectric material on the surface of a first conductivity monocrystalline semiconductor layer (3), providing an opening (8) in said dielectric material with dimensions correlatable with a gate electrode (13) thereby exposing the surface (6) of said layer (3),

implanting conductivity affecting impurities into a portion of said layer (3) vertically separated from said surface (6), in an area defined by said opening (8),

providing a gate electrode (13) in contact with said surface (6) in said opening (8), and providing source and drain electrodes (11, 12) in contact with said surface (6) remote from said opening (8).

9. The process of claim 8 wherein said semiconductor layer (3) is GaAs.

10. The process of claim 8 or 9 wherein said dielectric material (7) is taken from the group of $SiO_2$ and $Si_3N_4$.

FIG. 1

FIG. 2

FIG. 3

FIG. 4

N-LAYER

P-IMPLANT

DOPING CORE (N OR P TYPE)

DISTANCE BELOW SURFACE

FIG. 5

NET DOPING

N-TYPE

P-TYPE

DISTANCE BELOW SURFACE

# FIG.6

# FIG.7

# FIG.8

IBM — YO 986 063

| | European Patent Office | **EUROPEAN SEARCH REPORT** | Application Number |

EP 88 10 4340

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | PATENT ABSTRACTS OF JAPAN, vol. 11, no. 11 (E-470)[2458], 13th January 1987; & JP-A-61 187 277 (MITSUBISHI ELECTRIC CORP.) 20-08-1986 * Abstract * --- | 1-10 | H 01 L 29/10 H 01 L 29/80 |
| X | EP-A-0 057 605 (SUMITOMO ELECTRIC INDUSTRIES LTD) * Figures 14-15F; page 29, line 7 - page 31, line 15 * --- | 1-7 | |
| A | PATENT ABSTRACTS OF JAPAN, vol. 6, no. 64 (E-103)[942], 23rd April 1982; & JP-A-57 4169 (TOKYO SHIBAURA DENKI K.K.) 09-01-1982 * Abstract * ----- | 1-7 | |

TECHNICAL FIELDS SEARCHED (Int. Cl.4)

H 01 L 29

The present search report has been drawn up for all claims

| Place of search | Date of completion of the search | Examiner |
|---|---|---|
| THE HAGUE | 20-07-1988 | MIMOUN B.J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)